Europäisches Patentamt

European Patent Office

Office européen des brevets

(19)

(11)     EP 0 708 526 B1

(12)     **FASCICULE DE BREVET EUROPEEN**

(45) Date de publication et mention
de la délivrance du brevet:
**03.05.2000   Bulletin 2000/18**

(51) Int Cl.⁷: **H03G 1/00**, H03H 11/24

(21) Numéro de dépôt: **95410117.6**

(22) Date de dépôt: **12.10.1995**

(54) **Résistance commandée en tension**

Spannungsgesteuerter Widerstand

Voltage controlled resistor

(84) Etats contractants désignés:
**DE FR GB IT**

(30) Priorité: **17.10.1994   FR 9412570**

(43) Date de publication de la demande:
**24.04.1996   Bulletin 1996/17**

(73) Titulaire: **STMicroelectronics S.A.**
**94250 Gentilly (FR)**

(72) Inventeurs:
• **Bernard, Patrick**
**F-38320 Poisat (FR)**

• **Bernard, Christophe**
**F-38520 Bourg d'Oisans (FR)**

(74) Mandataire: **de Beaumont, Michel**
**1bis, rue Champollion**
**38000 Grenoble (FR)**

(56) Documents cités:
**EP-A- 0 220 043**          **DE-A- 2 403 756**
**US-A- 4 868 519**

## Description

La présente invention concerne une résistance commandée en tension, c'est-à-dire un composant dont la résistance entre deux bornes varie en fonction d'une tension de commande appliquée sur une borne de commande.

De telles résistances commandées en tension sont, par exemple, utilisées dans des systèmes de réglage automatique de gain qui servent à obtenir un signal d'amplitude sensiblement constante, ou n'excédant pas une certaine limite, à partir d'un signal d'amplitude variable.

Pour obtenir une résistance commandée en tension, on utilise souvent un transistor MOS en zone linéaire (c'est-à-dire avec une tension drain-source voisine de zéro), et l'on applique la tension de commande entre la grille et la source du transistor MOS. Une telle résistance commandée en tension présente l'inconvénient de faire subir à un signal traité une distorsion de l'ordre de 1 % car, à tension grille-source constante, la tension drain-source du transistor MOS n'est pas exactement proportionnelle au courant circulant dans le transistor.

Un objet de la présente invention est de réaliser une résistance commandée en tension entraînant une distorsion particulièrement faible.

Pour atteindre cet objet, la présente invention prévoit de fournir à un transistor MOS une tension grille-source qui est une fonction linéaire d'une tension de commande et de la tension drain-source du transistor. Cette fonction linéaire diffère selon les polarités que peut avoir la tension drain-source.

La présente invention vise plus particulièrement une résistance commandée en tension comprenant un transistor MOS dont le drain et la source constituent les bornes de la résistance. Le transistor MOS reçoit entre sa grille et sa source la somme d'une tension de commande et du produit de la tension drain-source par un coefficient compris entre 0,5 et 2,5.

Selon un mode de réalisation de la présente invention, le coefficient est égal à 0,5 dans le cas où la tension drain-source du transistor MOS est toujours de même polarité.

Selon un mode de réalisation de la présente invention, le coefficient est voisin de 1 dans le cas où la tension drain-source du transistor MOS a une polarité variable.

Selon un mode de réalisation de la présente invention, la résistance commandée est montée dans un pont diviseur, la source du transistor MOS étant reliée à la masse, et la grille étant commandée par un amplificateur opérationnel monté en additionneur pondéré de la tension de drain et de la tension de commande.

Selon un mode de réalisation de la présente invention, la tension de drain du transistor MOS est fournie à l'amplificateur opérationnel par un transistor suiveur, le décalage introduit par ce transistor suiveur étant compensé dans une boucle de contre-réaction de l'amplificateur opérationnel par un transistor monté en diode.

Selon un mode de réalisation de la présente invention, le transistor MOS est à canal N et le transistor suiveur est un transistor bipolaire PNP ou MOS à canal P polarisé par une source de courant reliée à un potentiel haut.

Selon un mode de réalisation de la présente invention, la résistance commandée est montée dans un circuit de réglage automatique de gain.

Ces objets, caractéristiques, et avantages ainsi que d'autres de la présente invention seront exposés plus en détail dans la description suivante de modes de réalisation particuliers faite à titre non-limitatif à l'aide des figures jointes parmi lesquelles :

la figure 1 représente un mode de réalisation schématique d'une résistance commandée en tension selon la présente invention ;
la figure 2 représente un mode de réalisation détaillé d'une résistance commandée en tension selon la présente invention ; et
la figure 3 représente un exemple d'application de résistance commandée selon la présente invention.

La présente invention est basée sur une analyse du comportement d'un transistor MOS en zone linéaire, c'est-à-dire où la valeur absolue de la tension drain-source du transistor MOS n'excède pas environ 0,5 volt. Dans cette zone linéaire, le courant de drain Id du transistor s'exprime de manière approchée par :

$$Id = K[(Vgs-Vt)Vds - \tfrac{1}{2}Vds^2] \qquad (1)$$

où Vgs est la tension grille-source, Vt la tension seuil, Vds la tension drain-source et K un coefficient constant égal au produit du rapport largeur sur longueur de canal, de la mobilité des porteurs de charge, et de la capacité d'oxyde par unité de surface.

Lorsqu'on se sert classiquement du transistor MOS en tant que résistance commandée, la tension Vgs correspond à la tension de commande. On constate alors que le courant de drain Id n'est pas une fonction linéaire de la tension drain-source Vds. Le transistor MOS ne se comporte pas comme une résistance parfaite.

Selon l'invention, on choisit d'appliquer sur la grille une tension de commande Vc augmentée de k fois la tension drain-source Vds. La tension Vgs s'exprime alors par :

$$Vgs = Vc + k \cdot Vds.$$

Le coefficient k est choisi de manière à annuler

les termes en $Vds^2$ dans la relation (1). Ceci est obtenu pour k=½. Le courant Id s'exprime alors par :

$$Id = K(Vc-Vt)Vds.$$

Dans ce cas, le rapport Vds/Id, c'est-à-dire la résistance entre drain et source du transistor MOS, est constant pour une tension de commande Vc donnée.

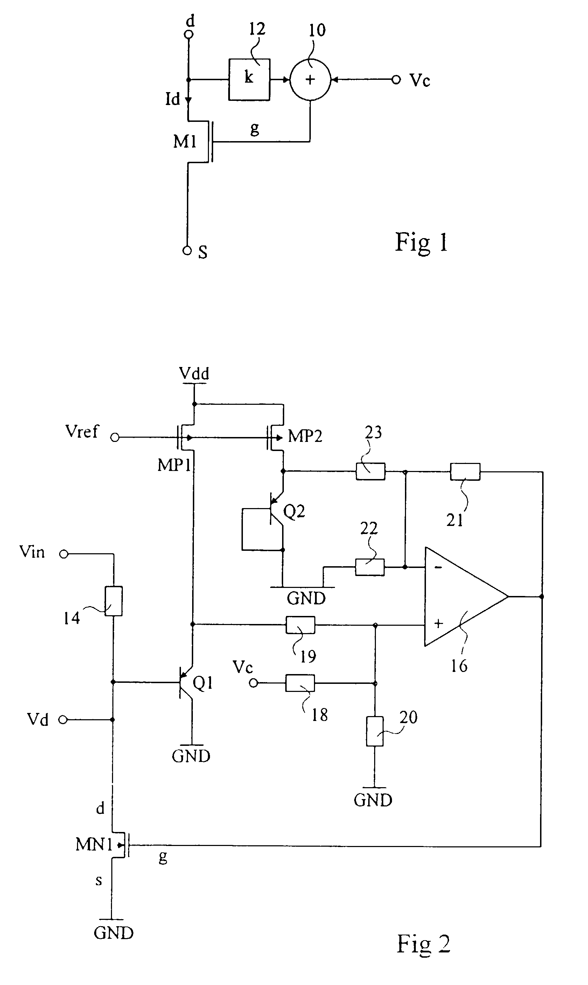

La figure 1 représente schématiquement une résistance commandée selon l'invention réalisée d'après ce principe. Elle comprend un transistor MOS M1 dont la grille g est reliée à la sortie d'un additionneur 10 recevant sur une première entrée la tension de commande Vc et sur une deuxième entrée la tension présente sur le drain d du transistor M1 par l'intermédiaire d'un circuit 12 qui multiplie cette tension de drain par le facteur k. Toutes les tensions (Vc, la tension de drain, la tension de grille) sont référencées par rapport à la source s du transistor M1.

Tant que la tension drain-source Vds est d'une polarité adaptée à celle du transistor M1 (par exemple une tension Vds positive avec un transistor M1 à canal N), le choix k=½ fournit le résultat optimal, c'est-à-dire que le transistor MOS M1 se comporte comme une résistance parfaite de valeur variant linéairement en fonction de la tension de commande Vc.

Si la polarité de la tension Vds s'inverse, le rôle des électrodes d et s est interverti, c'est-à-dire que l'électrode d constitue la source et l'électrode s le drain. Le courant de drain Id s'exprime alors par :

$$Id = K[(Vgd-Vt_2)Vds - \tfrac{1}{2}Vds^2] \qquad (2)$$

où Vgd est la tension entre la grille g et l'électrode d devenue la source, et $Vt_2$ est une nouvelle tension seuil qui s'exprime de manière approchée par $Vt_2 = Vt + a \cdot Vds$, où <u>a</u> est un coefficient d'effet de substrat compris entre 0,5 et 1 selon la technologie utilisée.

En outre, l'additionneur 10 fournit une tension Vgs qui est toujours référencée par rapport à l'électrode s. Ainsi, en exprimant la relation (2) en fonction de la tension Vgs et de la tension Vt, on obtient :

$$Id = K[(Vgs-Vt)Vds - (1,5 + a)Vds^2] \qquad (3)$$

Dans ce cas, pour supprimer les termes en $Vds^2$, la valeur à choisir du coefficient k est 1,5 + a. Par conséquent, si la tension drain-source du transistor M1 est alternative, il convient de réaliser un compromis de choix du coefficient k. On obtient un bon compromis pour k=1 ; la résistance commandée selon l'invention entraîne alors une distorsion de l'ordre de 0,1 %. Bien entendu, si la polarité de la tension Vds ne varie pas, la distorsion est nettement plus faible avec un coefficient k=½.

La figure 2 représente un mode de réalisation pratique d'une résistance commandée selon l'invention. Cette résistance commandée comporte un transistor MOS à canal N MN1 disposé dans un pont diviseur. La source s du transistor MN1 est reliée à la masse GND et son drain d est relié par une résistance 14 à une tension à diviser Vin. La tension de sortie Vd du pont est prélevée sur le drain du transistor MN1. La grille g du transistor MN1 est commandée par la sortie d'un amplificateur opérationnel 16 monté de manière classique en additionneur. Les tensions à additionner sont fournies à l'entrée non-inverseuse de l'amplificateur 16 par l'intermédiaire de résistances respectives 18 et 19. Cette entrée non-inverseuse est également reliée à la masse GND par une résistance 20. L'entrée inverseuse de l'amplificateur 16 est reliée à la sortie de l'amplificateur par une résistance 21 et à la masse par une résistance 22.

Avec cette configuration, toutes les tensions sont référencées par rapport à la source s du transistor MN1, qui est reliée à la masse GND. On évite ainsi des problèmes qui pourraient se poser avec un transistor MN1 à source flottante.

La tension de commande Vc est appliquée à l'amplificateur 16 par l'intermédiaire de la résistance 18. En théorie, il suffirait d'appliquer la tension (Vd) du drain du transistor MN1 à l'amplificateur 16 par l'intermédiaire de la résistance 19. Toutefois, en pratique, si la tension Vd est faible ou même négative, l'amplificateur 16 est incapable de la traiter. En outre, l'impédance d'entrée de l'amplificateur 16 (dépendant des résistances 18 à 20) est non négligeable par rapport aux résistances du pont diviseur (MN1, 14) et pourrait donc perturber le fonctionnement du pont. Pour éviter ces problèmes, comme cela est représenté, la tension de drain est décalée vers le haut d'une tension base-émetteur Vbe grâce à un transistor PNP Q1 monté en suiveur. L'émetteur du transistor Q1 est relié à la résistance 19 et polarisé par l'intermédiaire d'une source de courant MP1 reliée à un potentiel d'alimentation haut Vdd. Le collecteur du transistor Q1 est relié à la masse. Bien entendu, il convient que ce décalage introduit par le transistor Q1 ne se retrouve pas à la sortie de l'amplificateur 16. Pour cela, un transistor PNP Q2 est prévu pour compenser ce décalage. Le transistor Q2 est monté en diode. Sa base et son collecteur sont connectés à la masse et son émetteur est relié à la tension Vdd par l'intermédiaire d'une source de courant MP2. L'entrée inverseuse de l'amplificateur 16 est reliée à l'émetteur du transistor Q2 par l'intermédiaire d'une résistance 23 de même valeur que la résistance 22. Les transistors Q1 et Q2 peuvent être remplacés par des transistors MOS à canal P, dont les substrats sont reliés aux sources.

Si une tension Vbe (du transistor Q1) ne suffit pas à relever suffisamment par rapport à la masse la valeur crête minimale de la tension Vd, on pourra disposer des diodes en série sur l'émetteur du transistor Q1, le même nombre de diodes étant disposé en série avec le transistor Q2.

Dans le cas où la tension d'entrée Vin est alternative, le coefficient k est réglé à 1 en choisissant toutes les résistances 18 à 22 de même valeur. Dans le cas où la tension d'entrée Vin est toujours positive, le coefficient k est réglé à ½ en choisissant la résistance 19 d'une valeur trois fois supérieure à celle de la résistance 18, les valeurs des résistances 20 à 23 étant égales à celle de la résistance 18.

Les sources de courant MP1 et MP2 sont constituées par des transistors MOS à canal P dont la grille est commandée par une tension de référence Vref.

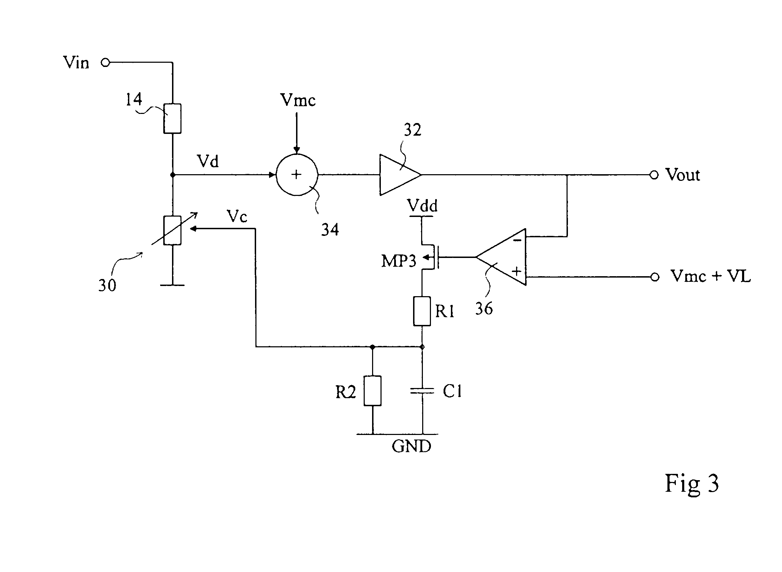

La figure 3 représente un exemple d'utilisation d'une résistance commandée selon la présente invention. Il s'agit ici d'un circuit de réglage automatique de gain. La résistance commandée, 30, est insérée dans un pont diviseur comme dans la figure 2. La tension de sortie Vd du pont est fournie à un amplificateur 32 par l'intermédiaire d'un additionneur 34 qui superpose à la tension Vd une tension de mode commun Vmc. La tension de sortie Vout de l'amplificateur 32 est appliquée à l'entrée inverseuse d'un comparateur 36. L'entrée non-inverseuse de ce comparateur reçoit la tension de mode commun Vmc augmentée d'une tension limite VL. La sortie du comparateur 36 est reliée à la grille d'un transistor MOS MP3 à canal P dont la source est reliée au potentiel d'alimentation Vdd et le drain est relié à la masse GND par un pont de résistances R1, R2. Ce pont de résistances fournit la tension de commande Vc de la résistance 30. Une capacité C1 est connectée à la masse, en parallèle sur la résistance R2.

Avec cette configuration, lorsque la tension Vd dépasse la tension limite VL, le comparateur 36 rend conducteur le transistor MP3 qui se met à charger la capacité C1 par l'intermédiaire de la résistance R1.

La tension de commande Vc croît et la valeur de la résistance 30 décroît en conséquence. La tension Vd se met donc à décroître jusqu'à devenir inférieure à la tension limite VL. Alors, le comparateur 36 rend non passant le transistor MP3 et la capacité C1 se décharge lentement dans la résistance R2. Ainsi, la résistance 30 augmente et la tension Vd augmente jusqu'au moment où cette tension Vd dépasse de nouveau la tension limite VL, et ainsi de suite.

**Revendications**

**1.** Résistance commandée en tension comprenant un transistor MOS (M1) dont le drain (d) et la source (s) constituent les bornes de la résistance, et recevant entre sa grille (g) et sa source la somme d'une tension de commande (Vc) et du produit de la tension drain-source (Vds) par un coefficient (k) voisin de 1 ; caractérisée en ce que la grille du transistor MOS est commandée par un amplificateur opérationnel (16) monté en additionneur pondéré de la tension de drain (Vd) et de la tension de commande (Vc), et en ce que la tension de drain (Vd) du transistor MOS est fournie à l'amplificateur opérationnel (16) par un transistor suiveur (Q1), le décalage introduit par ce transistor suiveur étant compensé dans une boucle de contre-réaction (21-23) de l'amplificateur opérationnel par un transistor monté en diode (Q2).

**2.** Résistance commandée selon la revendication 1, caractérisée en ce que le transistor MOS est à canal N et le transistor suiveur (Q1) est un transistor bipolaire PNP ou MOS à canal P polarisé par une source de courant (MP1) reliée à un potentiel haut (Vdd).

**3.** Résistance commandée selon la revendication 1, caractérisée en ce qu'elle est montée dans un pont diviseur (MN1, 14) d'un circuit de réglage automatique de gain, la source du transistor MOS étant reliée à la masse (GND).

**Patentansprüche**

**1.** Spannungsgesteuerter Widerstand mit einem MOS-Transistor (M1), dessen Drain-Anschluß (d) und Source-Anschluß (s) die Anschlüsse des Widerstands bilden, und der zwischen seinem Gate (g) und seinem Source-Anschluß die Summe einer Steuerspannung (Vc) und des Produkts aus der Drain-Source-Spannung (Vds) mit einem Koeffizienten (k) vom Betrag benachbart 1 zugeführt erhält, dadurch gekennzeichnet, daß das Gate des MOS-Transistors durch einen Operationsverstärker (16) gesteuert wird, der als Addiervorrichtung zur wichtenden Addition der Drain-Spannung (Vd) und der Steuerspannung (Vc) geschaltet ist, und daß die Drain-Spannung (Vd) des MOS-Transistors dem Operationsverstärker (16) über einen Folger-Transistor (Q1) zugeführt wird, wobei die durch diesen Folger-Transistor eingeführte Versetzung bzw. Verschiebung in einer Gegenkopplungsschleife (21-23) des Operationsverstärkers durch einen als Diode geschalteten Transistor (Q2) kompensiert wird.

**2.** Gesteuerter Widerstand nach Anspruch 1, dadurch gekennzeichnet, daß der MOS-Transistor ein N-Kanal-Transistor ist und daß der Folger-Transistor (Q1) ein PNP-Bipolar-Transistor oder ein P-Kanal-MOS-Transistor ist, der durch eine mit einem hohen Potential (Vdd) verbundene Stromquelle (MP1) vorgespannt ist.

**3.** Gesteuerter Widerstand nach Anspruch 1, dadurch gekennzeichnet, daß er in einer Teilerbrücke (MN1, 14) einer automatischen Verstärkungsregelschaltung angeordnet ist, wobei der Source-Anschluß des MOS-Transistors mit Masse (GND) verbunden ist.

## Claims

1. A voltage-controlled resistor including a MOS transistor (M1), whose drain (d) and source (s) constitute the terminals of the resistor, wherein the MOS transistor receives, between its gate (g) and its source, the sum of a control voltage (Vc) and of the product of the drain-source voltage (Vds) by a coefficient (k) close to 1; characterized in that the gate of the MOS transistor is controlled by an operational amplifier (16) mounted as a weighted adder of the drain voltage (Vd) and of the control voltage (Vc) and in that the drain voltage (Vd) of the MOS transistor is provided to the operational amplifier (16) through a follower transistor (Q1), the offset introduced by said follower transistor being compensated for in a negative feedback loop (21-23) of the operational amplifier through a diode-connected transistor (Q2).

2. The controlled resistor of claim 1, characterized in that the MOS transistor is an N-channel MOS transistor, and the follower transistor (Q1) is a PNP or P-channel MOS transistor biased by a current source (MP1) connected to a high voltage (Vdd).

3. The controlled resistor of claim 1, characterized in that it is connected in a dividing bridge (MN1, 14) of an automatic gain control circuit, the source of the MOS transistor being connected to ground (GND).

Fig 1

Fig 2

6

Fig 3